## Europäisches Patentamt

(19) **European Patent Office**

**Office européen des brevets**

(11) Numéro de publication: **0 082 901**
**B1**

(12) **FASCICULE DE BREVET EUROPEEN**

(45) Date de publication du fascicule du brevet:
**27.03.85**

(51) Int. Cl.⁴: **H 04 L 7/02, H 03 L 7/00**

(21) Numéro de dépôt: **81430044.8**

(22) Date de dépôt: **29.12.81**

(54) **Dispositif de synchronisation d'horloge et de données dans un système de transmission.**

(43) Date de publication de la demande:
**06.07.83 Bulletin 83/27**

(45) Mention de la délivrance du brevet:
**27.03.85 Bulletin 85/13**

(84) Etats contractants désignés:
**DE FR GB**

(56) Documents cités:
**EP - A - 0 015 014**
**EP - A - 0 036 084**
**US - A - 3 778 549**

**DAVIES, D.W. et al.: "Communication networks for computers", 1973, pages 166-169, Wiley, London, GB IBM TECHNICAL DISCLOSURE BULLETIN, vol. 22, no. 10, mars 1980, pages 4597-4599, New York, US G. EPENOY et al.: "Elastic Buffer with Automatic Shift Correction Capability"**

(73) Titulaire: **International Business Machines Corporation, Old Orchard Road, Armonk, N.Y. 10504 (US)**
(84) Etats contractants désignés: **DE GB**

(73) Titulaire: **Compagnie IBM FRANCE, 5 Place Vendôme, F-75000 Paris 1er (FR)**
(84) Etats contractants désignés: **FR**

(72) Inventeur: **Abbiate, Jean-Claude, Villa Grueia-Les Vaquières, F-06610 La Gaude (FR)**

(74) Mandataire: **Tublana, Max, Compagnie IBM France Département de Propriété Industrielle, F-06610 La Gaude (FR)**

## Description

La présente invention concerne les systèmes de transmission de données numériques, et plus précisément un dispositif de synchronisation d'un modem sur des horloges externes.

Dans les systèmes de transmission de données numériques, des séquences de bits sont échangées entre terminaux à travers un canal de transmission, après avoir en général subi, côté terminal destinataire une opération dite de démodulation. Or les bits, ou groupes de bits convertis en symboles, sont transmis un à un à des instants réqulièrement espacés, dits instans de signalistion définis par une horloge d'émission. Par conséquent, l'onde transmise n'est représentative de données qu'à ces instants et ceux-ci doivent être définis de manière précise. L'horloge d'émission est souvent constituée par un oscillateur de type dit à verrouillage de phase numérique (PLO). L'oscillateur de type PLO comporte un oscillateur à quartz donc précis et stable, travaillant à une fréquence nettement supérieure à la fréquence horloge désirée. L'onde de l'oscillateur à quartz passe par des étages diviseurs de fréquence dont la sortie fournit un signal de fréquence horloge. En outre, l'oscillateur de type PLO permet un ajustement, selon les besoins de la phase du signal horloge, par modification contrôlée du facteur de division des étages diviseurs.

Ainsi, l'émetteur peut, dans une certaine mesure, synchroniser les opérations de prélèvement et traitement en vue d'émission, des bits qui lui sont fournis parun terminal et ce au rythme de fonctionnement dudit terminal. Dans certains cas l'action sur l'oscillateur de type PLO ne permet pas de régler convenablement les problèmes de synchronisation. C'est notamment le cas lorsque la phase du signal horloge définissant le rythme des bits de données varie trop brusquement. On utilise alors d'autres moyens tels que celui décrit dans le Technical Disclosure Bulletin d'IBM, Vol. 22, No. 10, Mars 1980, pages 4597 à 4599. L'adaptation entre le rythme auquel les données sont fournies par un terminal et celui auquel l'émetteur les prélève, est réalisée à l'aide de registres tampons dits élastiques. Outre le fait que du matériel supplémentaire est nécessaire pour assurer la fonction tampon citée ci-dessus, l'élasticité des registres est limitée par leurs tailles et par les différences entre les rythmes de leurs chargements et déchargements. On comprend aisément que dans certains cas de fonctionnement, des bits puisssent être perdus entraînant donc des erreurs de transmission.

De plus, dans les systèmes de transmission modernes, un même émetteur est relié à plusieurs terminaux à travers un multiplicateur d'entrées. Bien que les terminaux individuellement reliés aux entrées, travaillent alternativement et de manière exclusive, il faut que l'horloge de l'émetteur puisse s'adapter rapidement à celle de chacun des terminaux. Or, dans certains cas, l'horloge d'un terminal peut être à un instant donné en opposition de phase et/ou à une fréquence différente de celle d'un autre terminal. Il faut que l'horloge de l'émetteur puisse passer d'une fréquence à une autre et surtout d'une phase à une autre, rapidement et sans entraîner de perte de données à transmettre au moment du changement du terminal dont les données sont à émettre. La solution des registres tampons élastiques est alors relativement onéreuse et complexe à mettre en oeuvre.

La présente invention a pour objet un dispositif d'horloge tampon assurant rapidement une compensation de la différence de phase entre l'horloge appartenant à l'émetteur et les horloges, dites externes, appartenant aux terminaux à desservir par ledit émetteur, et ce tout en évitant une perte de données (bits) à transmettre.

Pour ce faire, le système d'émission de données est pourvu d'un circuit tampon d'horloge et de données recevant les signaux de données à transmettre à l'émetteur ainsi qu'un signal dit d'horloge externe régissant le rythme et la phase de l'envoi de ces données par le terminal correspondant. Ledit circuit tampon est pourvu d'une horloge à verrouillage de phase destinée à engendrer un signal dit d'horloge reconstituée, signal auquel l'horloge de l'émetteur devra s'adapter. Ladite horloge à verrouillage de phase est commandée par un signal dit de référence fourni par un registre à décalage d'horloge, lequel registre est chargé par ledit signal d'horloge externe qu'il décale au rhytme d'un signal dit d'horloge commutée. Le signal d'horloge commutée est lui-même engendré en comparant la phase du signal d'horloge reconstituée à celle de l'horloge externe et en engendrant, à partir d'un instant dit initial, un signal oscillant à une fréquence rapide durant une fraction du premier cycle d'horloge externe suivant ledit instant initial, fraction de cycle correspondant au déphasage du signal d'horloge reconstituée, par rapport au signal d'horloge externe, et à une fréquence lente subséquemment. Ce même signal d'horloge commutée sert aussi à commander un autre registre à décalage dit registre de données chargé par ledit signal de données à transmettre. Ledit instant initial est défini par le changement d'état logique d'un signal traduisant une demande pour émettre formulée par le terminal.

D'autres objets, caractéristiques et avantages de la présente invention ressortiront mieux de l'exposé qui suit, fait en référence aux dessins annexés à ce texte, qui représentent un mode de réalisation préféré de celle-ci.

Fig. 1 représente un exemple de réseau de transmission.

Fig. 2 représente un détail du réseau de la fig. 1.

Fig. 3A et 3B représent des détails des interfaces des circuits 34 et 36 de la fig. 2.

Fig. 4 représente le circuit 50 de la fig. 3B.

Fig. 5 représente un schéma du dispositif tampon 52 de la fig. 3B.

Fig. 6 est un diagramme temporel du fonctionnement de l'invention.

Fig. 7 et 8 est un schéma d'un dispositif dit d'horloge à verrouillage de phase de la fig. 5.

Fig. 9 est un schéma du dispositif 98 de la fig. 5.

Fig. 10 est un schéma de l'ensemble 100 et 102 de la fig. 5.

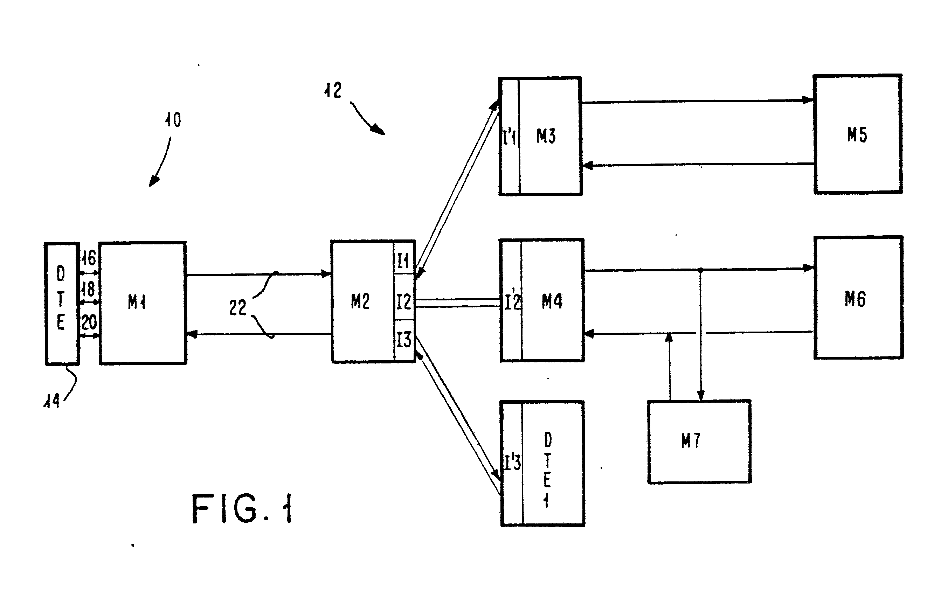

La fig. 1 représente un exemple de réseau de transmission numérique. A une extrémité du réseau se trouve un ensemble 10 dit local comprenant un terminal 14 (DTE) relié à un circuit d'émission/réception M1 habituellement appelé modem (modulateur/démodulateur). Le modem M1 est chargé d'effectuer les émissions des données provenant du terminal 14 et la réception des données provenant de la ligne 22 et qui sont destinées à ce même terminal. Les échanges de données entre terminal 14 et modem M1 se font au travers de canaux 16, 18, 20. A l'autre extrémité du réseau se trouve un ensemble 12 dit éloigné. Cet ensemble 12 comporte un modem M2 relié au modem M1 par des lignes constituant un canal de transmission bidirectionnel 22. Le modem M2 est en outre relié à travers des inter-faces I1 et I2 à d'autres modems M3 et M4 dits tributaires, qui aux desservent d'autres modems M5, M6, M7 auxquels sont rattachés des terminaux (non représentés). Les modems M1 à M7 peuvent être choisis parmi les modems IBM de type 3863 ou 3864 ou 3865. Le modem M2 dessert en outre un terminal (DTE1) à travers un circuit d'interface I3. Comme le montre la fig. 1, le modem M2 dessert donc plusieurs terminaux (ou autres modems). Le problème signalé plus haut, et dû à la multiplicité d'entrées se pose donc au niveau du modem M2. On notera que, bien que l'on ait représenté un réseau dans lequel le nombre d'éléments directement desservis par le modem M2 est limité à trois, à savoir le terminal DTE1 et les modems M3 et M4, ce nombre et la constitution de sec composants ne sont nullement limitatifs, du moins pour ce qui concerne l'invention, comme on le verra plus loin. De plus, pour ce qui concerne l'invention, la distinction entre modems M3, M4 et terminal DTE1 importe peu. On pourra les considérer tous comme des terminaux rattachés au modem M2.

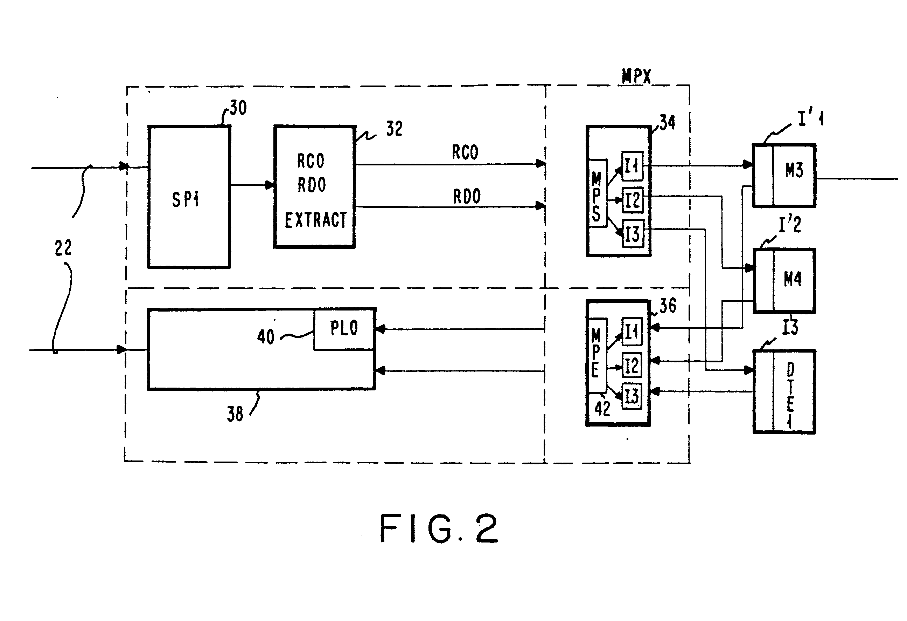

On a représenté sur la fig. 2 une vue plus détaillée du modem M2 de manière à permettre de mieux situer l'invention. On notera tout d'abord que l'on a scindé le modem en deux parties dont l'une, la partie supérieure, représente les dispositifs de réception, et l'autre, les dispositifs d'émission. Fonctionnellement, le récepteur comporte trois parties 30, 32 et 34. En 30 s'effectue une fonction (SP1) dite de traitement du signal reçu via la ligne 22. En 32, les signaux dits d'horloge de réception (RC0) et de données (RD0) sont extraits du signal traité par SP1. Les données RD0 sont ensuite orientées en 34 vers leurs destinataires respectifs à savoir modems M3, M4 ou terminal DTE1 en passant par un dispositif MPS et par les circuits d'interfaces I1, I2

ou I3. L'orientation des données proprement dites résulte d'une opération de démultiplexage effectuée dans un dispositif multiplexeur/démul-tiplexeur MPX. Des informations détaillées sur les moyens de traitement du signal reçu et surtout sur les moyens de récupération du signal d'horloge (RC0) pourront être trouvées notam-ment dans la demande de brevet européen No. 81101072.7 déposée le 16 février 1981 par la demanderesse et publiée sous le No. 0 036 084. En bref, le signal d'horloge de réception (RC0) est engendré dans le récepteur à l'aide d'un oscillateur PLO ajusté à partir d'informations extraites du signal reçu et traité en SP1. C'est cette même horloge qui contrôle l'extraction des données (RD0) du signal reçu. Quant à l'orientation correcte des informations reçues (bits de données) vers l'interface destinataire, elle résulte de l'utilisation d'une information »d'adresse« accompagnant les données reçues. Côté réception la synchronisation dans le temps, des différentes opérations à réaliser est effectuée sous le contrôle du signal d'horloge (RC0) reçu. Il n'y a donc au point de vue synchronisation, pas de problème particulier à résoundre pour éviter des désaccord d'horloges. Il n'en est pas de même côté émission.

La partie inférieure de la fig. 2 a été représentée de manière à souligner la répartition des grandes fonctions d'émission, et à permettre de bien situer l'invention dans son contexte. Les modems M3 et M4 et le terminal DTE1 sont res-pectivement reliés aux interfaces I1, I2 et I3 ap-partenant à un dispositif 36 d'orientation des données à transmettre vers l'émetteur proprement dit, 38. L'émetteur 38 du type de celui utilisé dans les modems IBM 3863 à 3865 travaille selon les techniques dites de modulation à double bandes latérales-porteuses en quadrature (DSB-QC). Les bits de données fournis par le terminal DTE1 et les modems M3 et M4 sont groupés selon des régles prédéterminées. L'émetteur 38 constitue par exemple des groupes de quatre bits (quadbits). Chaque quad-bit définit un symbole de données $a_i$, lequel est à son tour converti en information discrète de phases et/ou d'amplitudes de porteuses à transmettre. Il est évident que toutes ces opérations doivent être synchronisées les unes par rapport aux autres. L'émetteur dispose pour ce faire, d'un oscillateur 40 ou horloge de type PLO. Or le terminal DTE1 et les modems M3 et M4 fournis-sent aux interfaces I1 à I3 des bits de données, et ce, à leurs propres rythmes à eux. On dit dans ce cas que le modem M2 travaille sur horloges externes. Pour que l'émission puisse se faire correctement, il est nécessaire, que les prélèvements de bits dans les interfaces I1 à I3 se fas-sent aux bons moments. Donc une adaptation à la fois en phase et en fréquence doit être effectuée entre le PLO 40 et les horloges externes, et ce, en évitant les pertes de données.

Le rôle de cette adaptation est dévolu ici au dispositif (MPE) 42 multiplicateur d'interfaces d'entrées. Ce dispositif se comporte comme un tampon entre les horloges des sources externes de données à transmettre et le PLO 40, de manière à neutraliser essentiellement tout effet dû au déphasage entre lesdites sources externes et le PLO 40. Plus précisément, le dispositif tampon 42 doit présenter à l'horloge 40 un signal dit d'horloge reconstituée XC0 sur lequel le PLO 40 pourra s'adjuster aisément, quel que soit le terminal en fonction. A noter que les sources externes fournissent des bits de données de manière exclusive. C'est-à-dire que lorsqu'une source fournit un bit, les autres attendent. Pour garantir en pratique cette exclusivité, les interfaces I1, I2, I3 peuvent aboutir sur un circuit d'exclusion que l'on décrira plus loin.

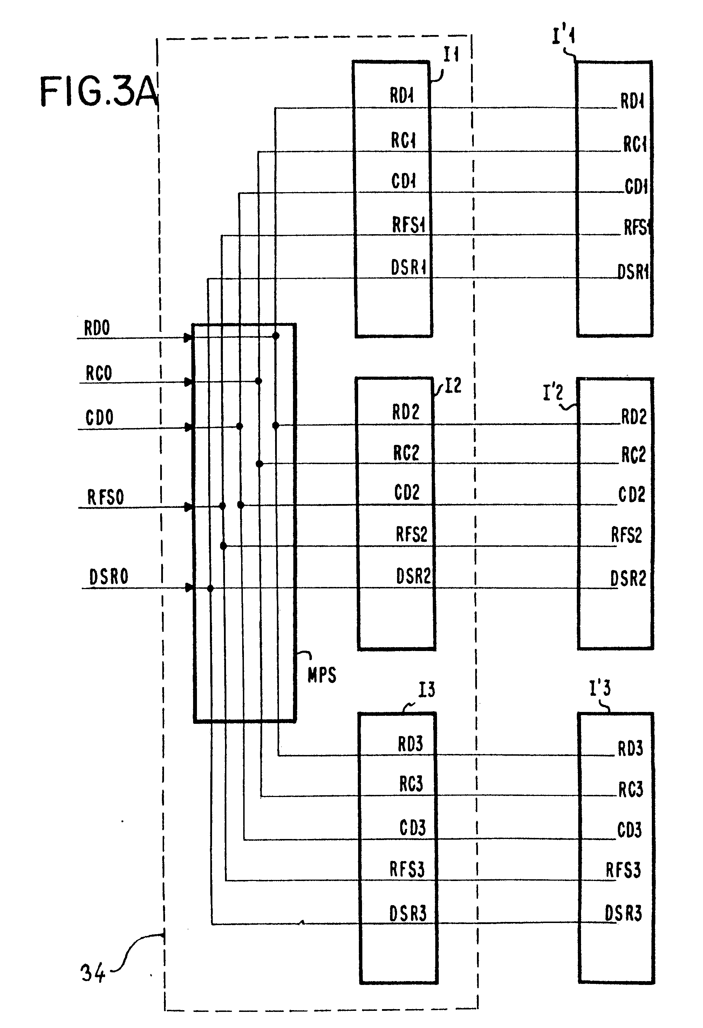

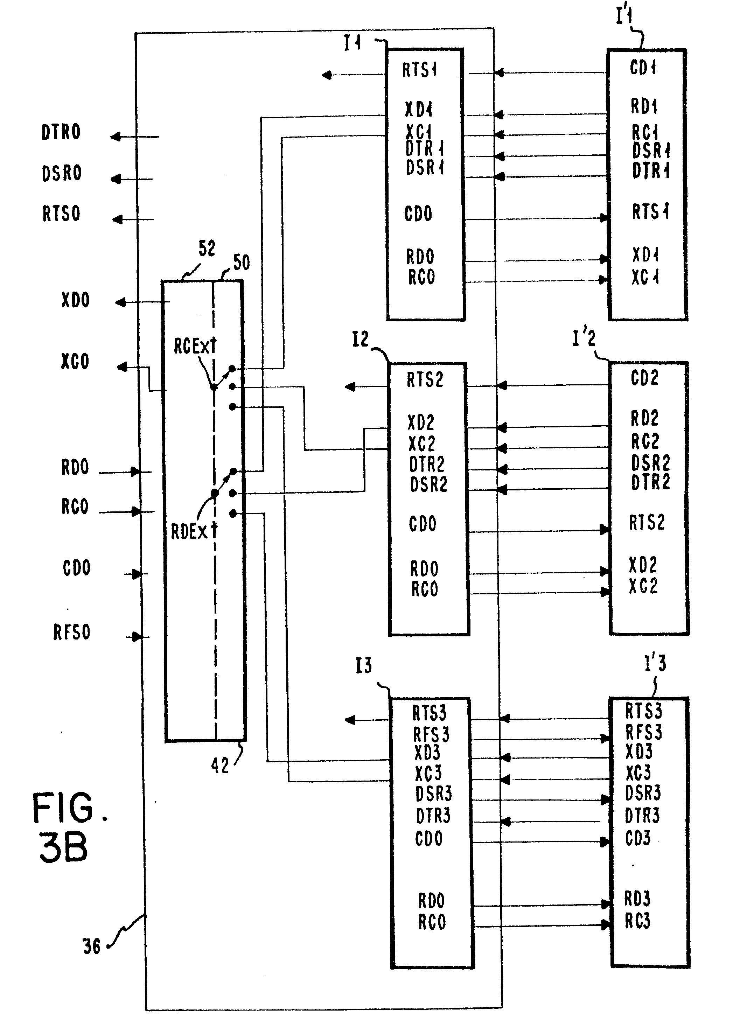

On a représenté sur les figures 3A et 3B, le détail des circuits d'interfaces I1, I2, I3 ainsi que de leurs correspondants I'1, I'2 et I'3 placés respectivement dans les modems M3, M4 et dans le terminal DTE1. Tous ces interfaces sont réalisés selon les normes CCITT et notamment conformément à l'Avis 24 du CCITT. Cet Avis définit des circuits de liaison numérotés dans la série »100«, de 102 à 192. On a repris ici les circuits du CCITT dont on a besoin pour décrire l'invention, circuits auxquels on a conservé les références CCITT et notamment:

Circuit 103 V24: Emission de données (XD):
Les signaux de données reçus par le modem M2, pour être transmis par celui-ci, passent par ce circuit.

Circuit 104 V24: Réception de données (RD):
Les signaux de données issus du modem M2 passent par ce circuit.

Circuit 105 V24: Demande pour Emettre (RTS):
Les signaux transmis sur ce circuit commandent le modem M2 et demandent de se mettre en état d'émettre dans la voie de données. Selon le niveau logique sur ce circuit, le modem se met en position d'émission sur sa voie de données, ou au contraire en position de non-transmission.

Circuit 106 V24: Prêt à Emettre (RFS):
Les signaux transmis sur ce circuit, indiquent si le modem est prêt à émettre des données sur la voie de données.

Circuit 107 V24: Poste de Données Prêt (DSR):
Les signaux transmis sur ce circuit indiquent si le modem M2 est prêt à fonctionner. L'un des états logiques de ce circuit indique que le modem est connecté à la ligne de transmission et qu'il est prêt à échanger avec le dispositif (M2, M3 ou DTE1) qui lui est connecté, d'autres signaux de commande pour provoquer l'échange de données.

Circuit 108/2 V24:
Equipement Terminal de Données Prêt (DTR):
Les signaux transmis sur ce circuit commandent la commutation du modem M2, pour le connecter sur la ligne ou le déconnecter. Le terminal (ou modem tributaire) est autorisé à présenter un niveau logique donné sur le circuit 108/2 chaque fois qu'il est prêt à émettre ou à recevoir des donnés.

Circuit 109 V24:
Détecteur de Signal de Ligne Reçu sur la Voie de données (CD):
On parle aussi dans ce cas de détection de porteuse.

Circuit 113 V24:
Base de Temps pour les Elements de Signal à l'Emission (XC):
Les signaux transmis sur ce circuit fournissent au modem, la base de temps (horloge externe) pour les éléments de signal.

N. B.
C'est précisément l'horloge externe dont la synchronisation aussi précise que possible sur l'horloge (PLO) 40 (ou inversement) est à réaliser.

Circuit 115 V24:
Base de Temps pour les Elements de Signal à la Réception (RC):
Les circuits ci-dessus ayant été précisés, on les a représentés sur les fig. 3A et 3B en leur associant un indice défini selon leur emplacement. L'indice »0« est utilisé pour le modem M2, l'indice »1« pour les interfaces I1 et I'1, l'indice »2« pour les interfaces I2 et I'2, l'indice »3« pour les interfaces I3 et I'3.

La fig. 3A représente les liaisons côté réception du modem M2 (partie supérieure de la fig. 2). On constate que le dispositif MPS multiplicateur de sorties est réduit à sa plus simple expression. Il connecte tout simplement les circuits RD0, RC0, CD0, RFS0 et DSR0, directement aux interfaces (I1, I'1), (I2, I'2) et (I3, I'3). Le multiplicateur de sorties MPS impose donc aux interfaces et de là aux modems M3, M4 et au terminal DTE1 le signal de base de temps RC0 (horloge) extrait des données par le dispositif 32 du récepteur. Le dispositif MPS distribue aussi les données RD0 à l'ensemble des interfaces. La sélection du dispositif réellement destinataire des données se fera par le destinataire lui-même par reconnaissance d'une adresse au sein des données.

La fig. 3B représente les dispositifs d'interconnexion des interfaces avec la partie émission du modem M2. A noter ici que pour les besoins de l'invention les modems M3 et M4 peuvent être considérés comme des terminaux. Comme on l'a indiqué plus haut, dans ce cas, les interconnexions sont plus difficiles à réaliser. Le dispositif multiplicateur d'interfaces d'entrées (MPE) est plus complexe que le dispositif MPS car il faut, synchroniser les prélèvements de données à émettre, c'est-à-dire, assurer notamment des adaptations réciproques des signaux d'horloges mis en opération, à savoir les horloges dites externes appartenant aux modems M3, M4 et au terminal DTE1 et fournir à l'horloge 40 un signal unique et aussi stable que possible, signal sur lequel l'horloge 40 pourra s'adapter facilement.

Il faut tout d'abord assurer, dès que l'un des interfaces I1, I2 ou I3 est en fonction, une exclusion des deux autres. C'est le rôle du circuit d'exclusion 50 appartenant au multiplicateur d'entrée MPE. Ce circuit d'exclusion fournit notamment des informations d'horloge externe (RC Ext) et de données (RD Ext) qui sont en fait les signaux d'horloge et de données fournis par l'interface retenu pour être servi par l'émetteur 38 après exclusion des autres. Un dispositif tampon de données et d'horloge 52, relié au circuit d'exclusion 50 d'une part et à l'émetteur 38 et son oscillateur PLO 40 d'autre part, assure la mise en bonne phase des données (XD0) présentée à l'émetteur 38 et fournit une information horloge reconstituée (XC0). L'information XC0 est destinée à assurer une bonne synchronisation dans le temps des données à émettre. C'est sur XC0 que l'horloge de l'émetteur 40 doit être réglée. XC0 devrait donc être aussi stable que possible en phase et en fréquence, quel que soit RC Ext.

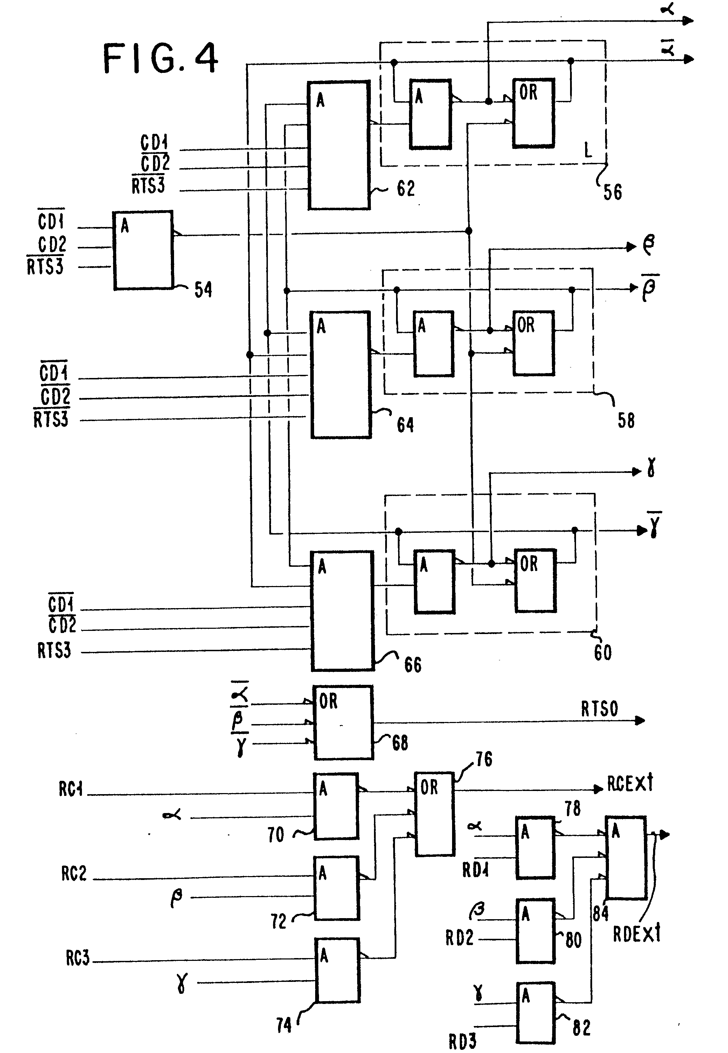

La fig. 4 représente un mode de réalisation du circuit d'exclusion 50. Les signaux $\overline{CD1}$, $\overline{CD2}$ et $\overline{RTS3}$ (la barre du dessus indiquant qu'il s'agit de signaux logiques inverses) des interfaces I1, I2 et I3 sont appliqués à l'entrée d'un circuit logique NON ET 54. La sortie du circuit 54 sert à déclencher trois bascules à verrouillage 56, 58 et 60 fournissant respectivement des signaux $\alpha, \beta, \gamma$ et leurs inverses $\overline{\alpha}, \overline{\beta}, \overline{\gamma}$. Les entrées d'enclenchement des bascules à verrouillage 56, 58 et 60 sont respectivement connectées aux sorties de circuits logiques NON ET 62, 64 et 66. Le circuit 62 reçoit sur ses entrées les signaux $\overline{\beta}, \overline{\gamma}$, CD1, $\overline{CD2}$ et $\overline{RTS3}$. Le circuit 64 reçoit $\overline{\alpha}, \overline{\beta}$, CD2, $\overline{CD1}$ et $\overline{RTS3}$. Et le circuit 66 reçoit $\overline{\alpha}, \overline{\beta}$, RTS3, $\overline{CD1}$ et $\overline{CD2}$. Un circuit logique OU 68 recevant les signaux $\overline{\alpha}, \overline{\beta}, \overline{\gamma}$ fournit une information RTS0 = $\alpha + \beta + \gamma$ qui signale à l'émetteur 38 la demande pour émettre formulée auprès du modem M2 par l'un des modems M3 ou M4, ou par le terminal DTE1. Les signaux RC1, RC2, RC3 d'horloges externes, signaux fournis par les interfaces I'1, I'2 et I'3 (à travers les circuits XC1, XC2 et XC3 des interfaces I1, I2 et I3) sont appliqués respectivement sur l'une des entrées d'un circuit NON ET 70, 72 ou 74. Les circuits 70, 72 et 74 reçoivent aussi respectivement sur une autre entrée, les signaux $\alpha, \beta$ et $\gamma$. Un circuit OU 76, dont les entrées sont reliées aux sorties des circuits 70, 72 et 74, fournit en sortie l'information RC Ext dite d'horloge externe, provenant de celui des »teminaux« M3, M4 ou DTE1 qui est choisi pour être servi lar l'émetteur 38 du modem M2. Il s'agira en fait, à un intant donné, du premier terminal ayant demandé à émettre et excluant les autres de ce fait. Les données RD1, RD2 et RD3 fournies par les interfaces I'1, I'2 et I'3 (à travers les circuits XD1, XD2 et XD3 des interfaces I1, I2 et I3) sont respectivement envoyées sur les entrées des circuits NON ET 78, 80 et 82. Ces mêmes circuits NON ET reçoivent respectivement sur une autre deleurs entrées, les signaux $\alpha, \beta$ et $\gamma$. Les sorties des circuits 78, 80 et 82 sont connectées aux entrées d'un circuit NON ET 84. La sortie du circuit 84 fournit les signaux RD Ext représentant les données à émettre fournies par l'un des »terminaux« M3, M4, ou DTE1.

Les signaux d'horloge RC Ext sont ceux qui doivent être traités pour présenter à l'oscillateur PLO 40 un signal relativement stable et conforme en phase et fréquence, et ce en évitant toute perturbation sur la transmission des données RD Ext à envoyer à l'émetteur 38. Les réglages en fréquence sont relativement simples à réaliser. Le signal RC Ext doit être à la même fréquence que l'horloge 40 de l'émetteur 38 du modem M2.

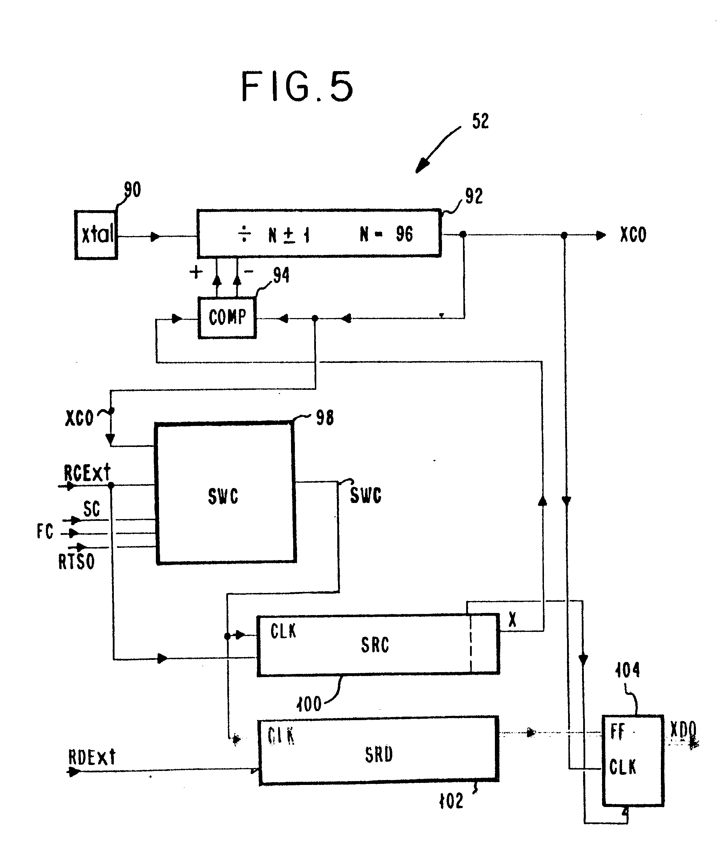

Les réglages de phase, qui eux sont les plus critiques, sont réalisés à l'aide du dispositif dont le schéma de principe est représenté sur la fig. 5, ce dispositif appartient au circuit 52 dit tampon d'horloge et de données. Ce circuit tampon 52 comprend tout d'abord une horloge de type PLO conventionnelle, c'est-à-dire, comportant essentiellement un oscillateur à quartz 90 relié à un circuit diviseur de fréquences 92. La sortie du diviseur 92, sortie sur laquelle sera prelevé le signal dit d'horloge reconstituée XC0 est envovée sur l'une des entrées d'un circuit comparateur de phase 94. Ce circuit comparateur 94 est équipé de deux sorties, reliées, aux entrées ( + ) et ( − ) du diviseur 92. Le circuit 90, 92, 94 est destiné à traquer le signal XC0.

Le signal RC Ext est appliqué sur l'une des entrées d'un circuit 98 dit d'horloge commutée. Une autre entrée du circuit 98 est reliée à la sortie du circuit tampon d'horloge et de données, sortie fournissant le signal d'horloge reconstituée, XC0. Trois autres signaux, l'un dit d'horloge rapide (FC), l'autre dit d'horloge lente (SC) et le troisième (RTS0) en provenance du circuit d'exclusion 50 sont aussi appliqués l'entrée du circuit 98. Le circuit 98 fournit un signal SWC, dit signal d'horloge commutée, qui sevira à assurer les commandes de décalages de deux registres à décalage 100 et 102. Le premier de ces registres à décalage, désigné par SRC constitue un registre à décalage d'horloge. Il a son entrée reliée à l'entré des signaux RC Ext et sa sortie (X) reliée à la seconde entrée (dite entrée de commande ou de référence) du comparateur de phase 94. Ce signal X constitue donc un signal d'horloge (externe) décalée. Le second regisre à décalage, désigné par SRD, a son entrée données reliée à l'entrée des signaux RD Ext. Il constitue un registre à décalage de données. La sortie du registre à décalage SRD 102 attaque une bascule 104 commandée par ailleurs par le signal d'horloge reconstituée XC0 (et par un signal d'inhibition dit INH prélevé sur l'avant dernier étage du registre SRC).

L'oscillateur à quartz 90 est réglé à une fréquence multiple (multiple ici égale à 96) de la fréquence Fb qui est la fréquence d'horloge choisie. Cette fréquence Fb sevant de référence aux PLO (90, 92, 94) est égale à celle de l'horloge 40 de l'émetteur. Le signal 96Fb est divisé dans le circuit diviseur 92 par un coefficient $N \pm 1$, avec $N = 96$. Lorsque le comparateur 94 applique un signal sur l'entrée (+) du diviseur 92, celui-ci effectue une division par un coefficient égal à 97 de la fréquence du signal oscillant à 96Fb, tandis que si le signal du comparateur 94 est appliqué à l'entrée (—) du diviseur 92, la fréquence du signal à 96Fb est divisée par 95. Lorsque ni l'une ni l'autre des sorties du comparateur 94 n'est excitée, le circuit 92 réalise une division de la fréquence du signal fourni par l'oscillateur à quartz 90 par un coefficient égal à 96. L'ensemble (90, 92, 94) constitue un oscillateur de type PLO.

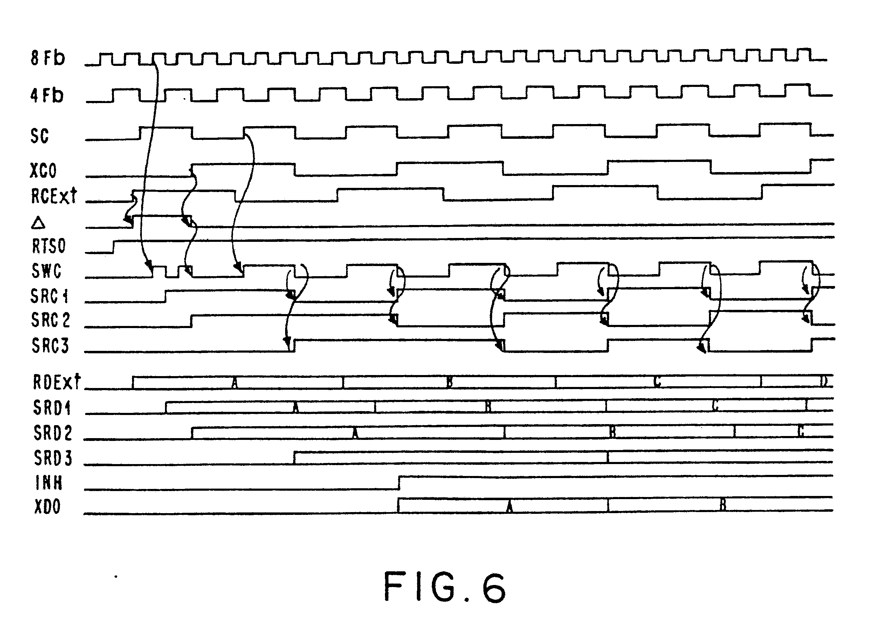

La fig. 6 représente un diagramme des opérations ralisées dans le temps par le dispositif de la fig. 5. On a représenté sur les trois premières lignes, les signaux aux fréquences 8Fb, 4Fb, 2Fb et Fb = XC0, dérivé à l'aide du PLO (90, 92, 94) de la fig. 5 du signal à 96Fb fourni par l'oscillateur à quartz 90. La cinquième ligne du diagramme représente le signal d'horloge externe RC Ext. La sixième ligne représente un signal $\Delta$ dit d'écart entre le premier front ascendant de RC Ext et le premier front ascendant du signal XC0 représenté sur la ligne 4 du diagramme. Par »premier« on entendra ici premier après un instant dit instant initial défini parle passage de RTS0 du niveau logique bas au niveau logique haut (voir ligne suivante du diagramme).

Ce signal $\Delta$ ne se produit qu'au moment où apparaît un flanc ascendant du signal RTS0. Durant l'intervalle de temps pendant lequel le signal $\Delta$ est au niveau haut, et à partir du moment où apparaît un flanc ascendant du signal horloge de fréquence rapide FC, le signal SWC (représenté sur la huitième ligne du diagramme) varie à cette même fréquence FC. Le reste du temps, c'est-à-dire lorsque $\Delta$ est au niveau bas, le signal SWC varie à la fréquence lente SC. On notera que sur le diagramme de la fig. 6, on a choisi FC = 8Fb et SC = 2Fb. Ces limites ont été choisies uniquement pour simplifier les diagrammes des temps. En réalité, comme on le verra plus loin, on choisira en pratique FC = 16Fb, lequel signal à 16Fb sera lui-même obtenu à partir d'un signal FC' à 32Fb.

Les trois lignes suivantes du diagramme sont respectivement désignées pr SRC1, SRC2 et SRC3. Les signaux qui y sont représentés, montrent l'évolution du contenu du registre à décalage SRC pour trois décalages successifs. Ce registre est chargé par le signal RC Ext et son contenu est décalé sous le contrôle des fronts descendants du signal d'horloge commutée SWC.

La ligne 12 montre des bits de données A, B, C, etc. se présentant à l'entrée du registre SRD. Ces bits de données apparaissent sur l'entrée du registre SRD, en phase avec le signal d'horloge externe RC Ext. Par contre, la phase de ces mêmes bits de données est initialement quelconque par rapport à celle du signal d'horloge reconstituée XC0. Mais comme le montrent les signaux des lignes du diagramme portant les références SRD1, SRD2 et SRD3, les données qui traduisent les valeurs des niveaux à l'entrée du registre SRD aux instants d'horloge commutée SWC sont décalées par ce signal d'horloge commutée. Les décalages se font sur les flancs descendants du signal SWC. On verra plus loin que l'on a en fait choisi des registres SRC et SRD à seize étages et non à trois étages. Comme le montre le signal représenté sur la ligne SRD3 du diagramme, le bit A, qui est celui dont on veut ajuster la phase, se trouve allongé par rapport aux bits B, C, D, etc. On utilise alors le signal alors le signal dit d'inhibition de porte, désigné par INH, pour tronquer convenablement le bit A à la même lonqueur que les autres, et de manière à ce qu'il se présente, bien en phase avec le signal d'horloge reconstituée. C'est ce que montre la ligne XD0 du diagramme, ligne représentant les données en phase à soumettre à l'émetteur 38. Ces données XD0 représentent donc le train de données à soumettre à l'émetteur 38.

On va maintenant préciser un mode de réalisation des différents éléments du dispositif tampon d'horloge et de données représenté sur la fig. 5.

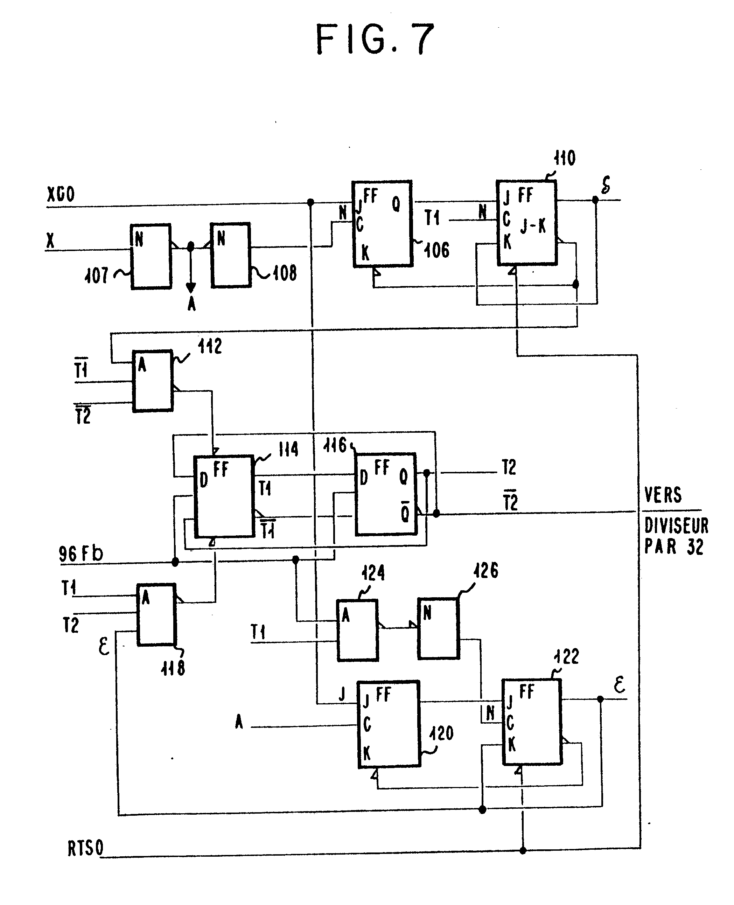

La fig. 7 représente les éléments de commande de la boucle de réaction de l'oscillateur PLO du dispositif tampon de la fig. 5. Il s'agit plus précisément d'une description de circuit appartenant aux dispositif 92 et 94. On y réalise une division par $N' = 3$, $N' - 1 = 2$ ou $N' + 1 = 4$ de la fréqence du signal à 96Fb fourni par un oscillateur à quartz 90. L'ajustement à la fréquence $(96 \pm 1)$Fb se fait à l'aide d'un second diviseur (non représenté) inclus dans le circuit 92 et en série avec le circuit dela fig. 7. Le signal XC0 dit d'horloge reconstituée fourni par le diviseur 92 est appliqué sur l'entrée J d'une bascule type J-K 106. Le signal X d'horloge décalée apparaissant à la sortie du registre à décalage SRC est apliqué à l'entrée d'un premier circuit inverseur 107 suivi d'un second circuit inverseur 108. La sotie du circuit inverseur 108 est appliquée à l'entrée C de la bascule J-K 106. On notera que l'on a porté une mention N sur le fil arrivant à l'entrée C de la bascule J-K 106. Ceci signifie que ladite bascule J-K lit le niveau du signal appliqué sur l'entrée J lorsque le signal sur l'entrée C est sur un flanc descendant (pente Négative). On mentionnera ailleurs P au lieu de N et il faudra entendre par là que c'est la pente positive du signal appliqué sur l'entrée C qui est prise en Considération. La sortie normale de la bascule 106 est appliquée à l'entrée J d'une autre bascule J-K portant la référence 110. La sortie normale (Q) de la bascule 110 est rebouclée sur l'entrée K de cette même bascule. On a désigné par $\delta$ le signal de la sortie Q de la bascule 110. L'entrée C de la bascule 110 reçoit un signal T1 que l'on précisera ultérieurement. La sortie inverse ($\bar{Q}$) de la bascule 110 est envoyée sur la bascule 106 pour bloquer celle-ci jusqu'à ce qu'un nouveau flanc descendant du signal XC0 apparaisse. Cette même sortie $\bar{Q}$ de la bascule 110 est envoyée sur l'une des entrées d'un circuit logique NON ET 112 pourvu de deux autres entrées recevant des signaux $\overline{T1}$ et $\overline{T2}$ (à préciser ultérieurement).

Le signal à la fréquence 96Fb fourni par l'oscillateur à quartz 90 est appliqué aux entrées de deux bascules bistables 114 et 116 disposées en cascade. La sortie normale de la bascule 114 fournit le signal T1. Les sorties de la bascule 114 sont reliées aux entrées de la bascule 116 qui, elle fournit le signal T2 dont l'inverse $\overline{T2}$ est envoyé vers le circuit diviseur de fréquence 94. Les sorties de la bascule 116 sont renvoyées à l'entrée de la bascule 114. La sortie du circuit NON ET 112 contrôle la bascule 14.

Les signaux T1 et T2 sont appliqués sur les entrées d'un circuit NON ET 118 ayant une troisième entrée recevant un signal $\varepsilon$. La sortie du circuit NON ET 118 contrôle la bascule 114.

Le signal A, prélevé à la sortie du circuit inverseur 107 est envoyé sur l'entrée C d'une bascule J-K 120. L'entrée J de cette même bascule J-K 120 reçoit le signal XC0 dit d'horloge reconstituée. La sortie normale de la bascule 120 est reliée à l'entrée d'une bascule J-K 122. La sortie normale de la bascule 122 fournit le signal $\varepsilon$ qui est envoyé sur l'entrée K de cette même bascule. La sortie inverse de la bascule 122 commande le blocage de la bascule J-K 120.

Un signal à la fréquence 96Fb fourni par l'oscillateur à quartz 90 est appliqué sur l'une des entrées d'un circuit NON ET 124, lequel est pourvu d'une seconde entrée recevant le signal T1. La sortie du circuit NON ET 124 est inversée en 126 avant d'être envoyée sur l'entrée C de la bascule J-K 122.

Enfin, le signal RTS0 est utilisé pour bloquer les bascules J-K 110 et 122.

On peut considérer que le circuit comprenant les éléments (106, 107, 108 et 110) sert à déceler et à signaler le retard entre le signal d'horloge reconstituée XC0 et le signal X dit d'horloge décalée. De même, le circuit (120, 122, 124 et 126) détecte et signale une avance de l'horloge reconstituée XC0 par rapport au signal d'horloge décalée.

L'ensemble des circuits (112, 114, 116, 118) réalise les divisions par 2, 3 ou 4 du signal à la fréquence 96Fb fourni par l'oscillateur à quartz 90. On définit trois états, l'un dit »stationnaire«, un autre dit »de retard« et le troisième dit »d'avance«. Durant l'état stationnaire, obtenu lorsque

$$\vartheta = 1 \text{ et } \varepsilon = 0 \text{ ou } \vartheta = 0 \text{ et } \varepsilon = 1,$$

le coefficient de division obtenu est 3. L'état retard correspondant à $\vartheta = \varepsilon = 0$ entraîne une division par 4. Et l'état avance, correspondant à $\vartheta = \varepsilon = 1$ entraîne une division par 2.

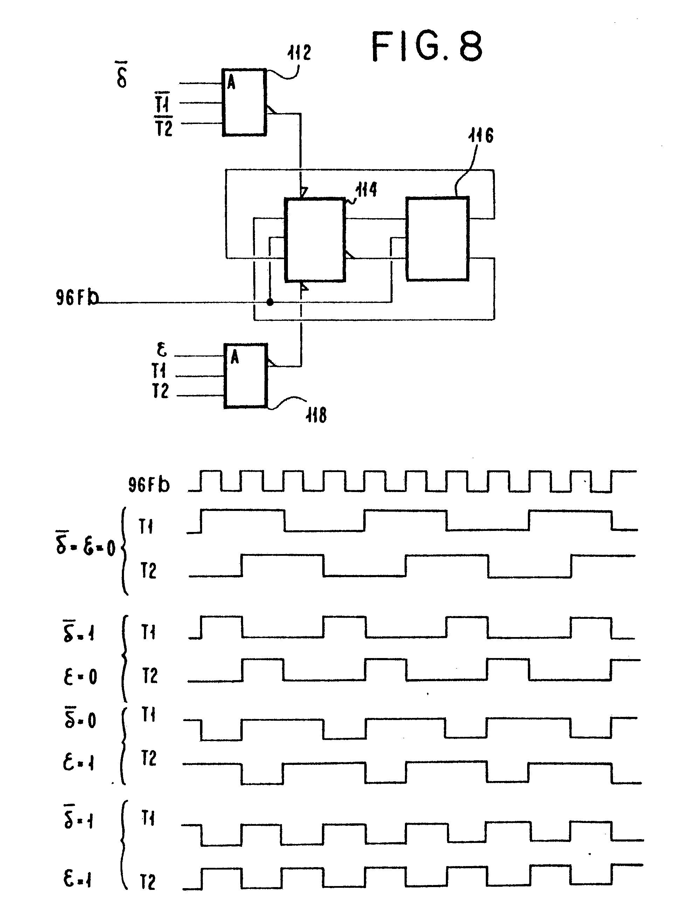

On a représenté sur la fig. 8, le dispositif réalisant les divisions de fréquences, ainsi que les diagrammes des signaux T1 et T2 obtenus. L'opération qui consiste à passer d'un coefficient de division 3 à un coefficient 2 ou 4 n'est réalisée qu'une fois par temps 1/Fb. Le coefficient de division est ramené à »3« dès que la sortie $\bar{Q}$ de la bascule 110 passe à un »1«.

La sortie $\overline{T2}$ de la bascule 116 attaque un circuit diviseur (non représenté) effectuant des divisions de fréquence par un coefficient égal à 32. L'ensemble des opérations des circuits 92 et 94 revient donc à ajouter ou retrancher »1« au coefficient N et ce une fois par intervalle de temps 1/Fb jusqu'à ce que le signal X dit d'horloge décalée tombe en phase avec XC0.

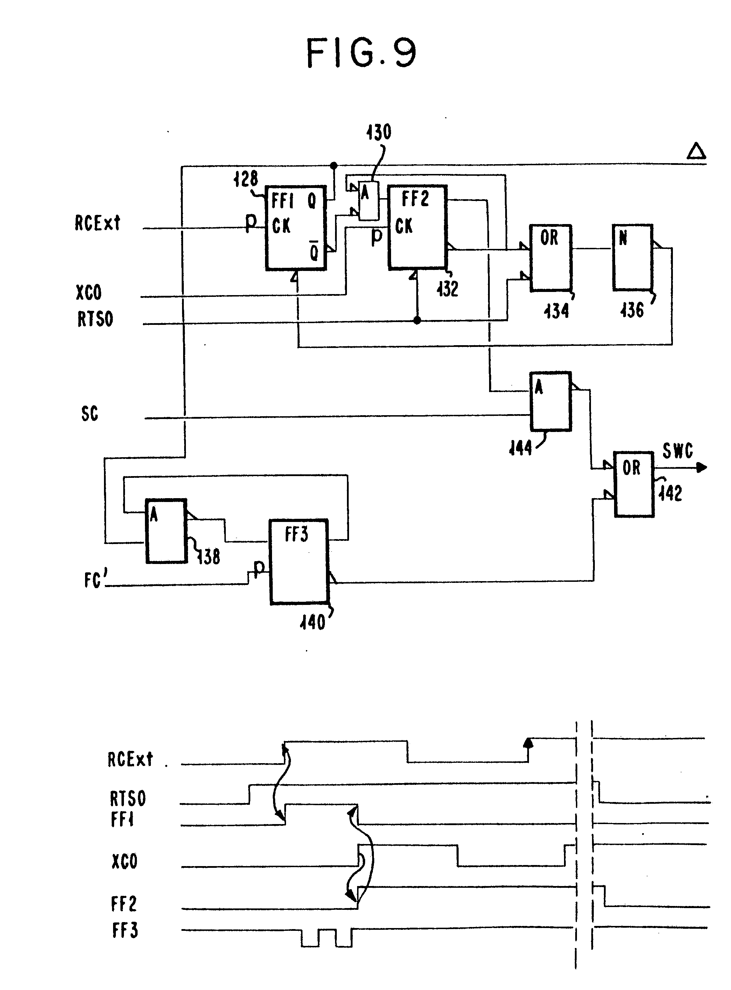

La fig. 9 montre un mode de réalisation du circuit 98 dit d'horloge commutée permettant d'engendrer le signal d'horloge commutée SWC. Cette même figure montre aussi un diagramme des signaux mis en jeu durant le fonctionnement du circuit 98.

Le signal d'horloge externe est appliqué à l'entrée d'une bascule 128. La sortie inverse ($\bar{Q}$) de cette même bascule 128 est appliquée à l'entrée d'un circuit NON ET 130. La sortie du circuit 130 est appliquée à l'entrée d'une bascule 132. Cette même bascule 132 reçoit le signal d'horloge reconstituée XC0. La sortie inverse de la bascule 132 est renvoyée sur l'entrée du circuit 130 et sur l'une des entrées d'un circuit NON ET 134. Une seconde entrée du circuit 134 reçoit le signal RTS0 en provenance du circuit d'exclusion 50. Ce même signal RTS0 est aussi appliqué à la bascule 132. La sortie du circuit 134 est inversée en 136 avant d'être renvoyée sur la bascule 128. L'ensemble 128 à 136 constitue un circuit de comparaison des phases de XC0 et RC Ext.

La sortie normale de la bascule 128 est envoyée à l'entrée d'un circuit NON ET 138. La sortie du circuit 138 est appliquée à l'entrée d'une bascule 140, bascule sous contrôle d'un signal FC' à la fréquence 32Fb. La sortie normale de la bascule 140 est renvoyée à l'entrée du circuit NON ET 138. La sortie inverse ($\bar{Q}$) de la bascule 140, sortie fournissant un signal à la fréquence 16Fb. Ce dernier signal est appliqué sur l'une des entrées d'un circuit NON ET 142, dont une seconde entrée est reliée à la sortie d'un circuit NON ET 144. Les entrées du circuit NON ET 144 reçoivent le signal SC à la fréquence 2Fb, et le signal de la sortie normale ($Q$) de la bascule 132. On obtient le signal d'horloge commutée SWC à la sortie du circuit 142. L'ensemble 142—144 se comporte donc comme une porte.

On a représenté dans la partie inférieure de la fig. 8, le diagramme des signaux obtenus à l'aide des circuits représentés dans la partie supérieure de cette même figure. La première ligne représente le signal RC Ext. La seconde ligne représente le signal RTS0. Les quatre lignes suivantes représentent respectivement FF1, XC0, FF2 et FF3. Les signaux FF1, FF2 et FF3 sont ceux délivrés respectivement par les bascules 128, 132 e 140.

L'apparition d'un front positif sur RC Ext fait basculer la bascule FF1 dont la sortie normale ($Q$) passe au niveau haut. Lorsque le signal XC0 passe au niveau haut, avec RTS0 au niveau haut, la bascule FF2 passe au niveau haut. Le niveau à la sortie de l'inverseur 136 devient bas et force FF1 à revenir au niveau bas. Le signal obtenu sur la sortie normale (Q) de la bascule 128 comporte donc une impulsion dont la durée correspond au déphasage entre le signal d'horloge externe RC Ext et le signal d'horloge reconstituée XC0. (La bascule 128 mesure donc le déphasage portant la référence $\Delta$ sur la fig. 6). Durant l'intervalle de temps où $\Delta$ est haut, la porte 138 est ouverte. A chaque front ascendant du signal FC' la bascule 140 lit le niveau logique appliqué sur son entrée D et reproduit ce niveau sur la sortie normale (Q). L'ensemble porte 138 et bascule 140 constitue donc un diviseur de fréquence par deux, opérant uniquement durant l'intervalle $\Delta=1$. On obtient alors le signal $\overline{FF3} = \overline{FC}$ à la fréquence 16Fb sur la sortie inverse ($\overline{Q}$) de la bascule 140.

La sortie normale (Q) de la bascule 132 commande l'ouverture d'une porte 144 dont l'entrée reçoit le signal SC à la fréquence 2Fb. Ce signal SC inversé est transmis en sortie de la porte 144. Un circuit 142 réalisant une fonction NON ET sur les signaux sortant des circuits 140 et 144 fournit sur sa sortie le signal SWC, c'est-à-dire un signal oscillant tantôt à FC = 16Fb et tantôt à SC = 2Fb.

Le signal RTS0 commande le blocage de la bascule 132. Pour que le circuit 128, 130, 132 reparte dans un cycle de fonctionnement, il faut que RTS0 repasse par un front ascendant. Ceci signifie que le signal d'exclusion cesse de desservir le modem (M3, M4) ou le terminal DTE1 en cours detraitement et passe ensuite au premier d'entre eux devant fournir un bit de données à l'émetteur 38.

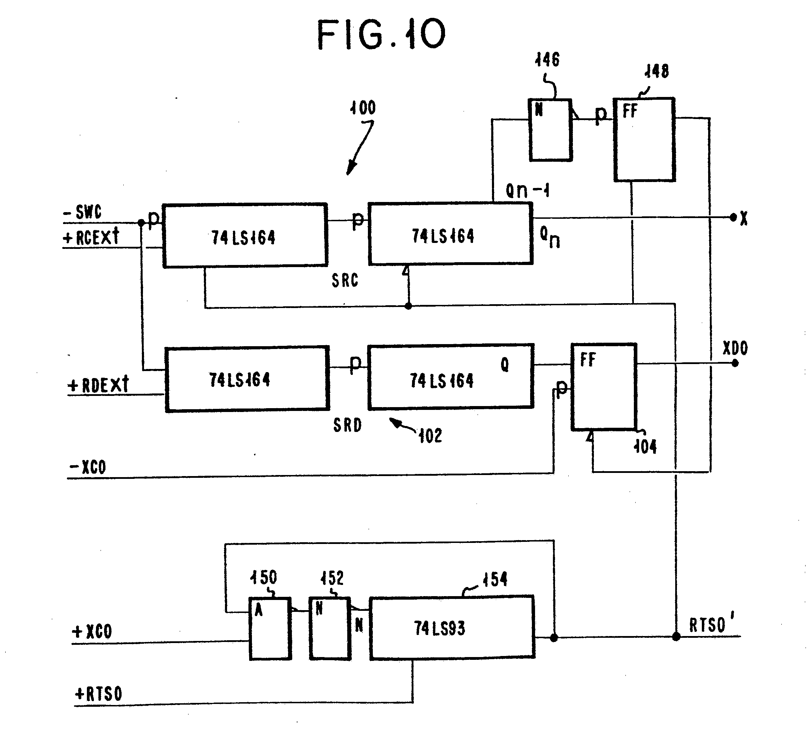

La fig. 10 montre enfin un mode de réalisation de la partie du circuit tampon de données et d'horloge représenté sur la fig. 5, partie comportant essentiellement les deux registres à décalage SRC et SRD et la bascule 104 se comportant comme une porte. Sur la fig. 10, chaque registre à décalage SRC et SRD a été représenté par deux registres en série. Ceci est uniquement dû au fait que l'on a utilisé des modules à 8 bits commercialisés par la Firme Texas Instrument sous la référence 74LS164. (On notera, que les circuits des autres figures comportent eux aussi des références numériques sous lesquelles ils sont commercialisés par la Firme indiquée ci-dessus). Comme on l'à déjà indiqué à propos de la fig. 5, les entrées des registres SRC et SRD reçoivent respectivement les signaux RC Ext et RD Ext. Ces signaux sont échantillonnés au rythme d'apparition du front positif du signal SWC.

La sortie Qn du registre SRC fournit le signal X dit horloge décalée, destiné au comparateur de phases 94. La sortie du registre SRD passe par la porte 104 dont l'ouverture est commandée par les fronts positifs du signal XC0. En outre, la sortie de l'avant dernier étage Qn-1 du registre à décalage SRC, après passage par un inverseur 146 suivi d'une bascule 148, fournit l'information dite d'inhibition INH qui inhibe l'ouverture de la porte 104 de manière à tronquer à la bonne longueur le premier bit de données introduit dans le registre SRD après passage de RTS0 du niveau

zéro au niveau un. Autrement dit, le premier bit introduit dans le registre SRD durant la période de réglage de l'horloge XC0 est tronqué, si nécessaire, à la même longueur que les bits normalement reçus. Ceci évite une première perturbation des bits de données à envoyer à l'émetteur 38.

En outre, le signal XC0 passe par un circuit introduisant un retard de 16 temps bits sur le signal RTS0. Ce circuit comporte un circuit logique ET 150 en série avec un inverseur 152 et un compteur binaire 154. La sortie du compteur binaire 154 (désignée par RTS0') sert à vider les registres SRC et SRD de leur contenu, après que le signal RTS0 soit retombé au niveau logique bas. Une seconde perturbation du train de bits à envoyer à l'émetteur 38 est ainsi évitée.

Comme on peut le noter à partir de la description qui précède, le système de l'invention ne fait aucune dinstinction sur l'origine exacte du signal d'horloge externe XC0. Que celui-ci provienne d'un modem (M3, M4) ou d'un terminal (DTE1) importe peu pour les besoins de l'invention. On peut donc admettre que dans tous les cas on puisse considérer l'organe fournissant le signal d'horloge externe comme un terminal.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

**Revendications**

1. Dispositif de synchronisation d'un système d'émission de données du genre comportant un émetteur (38) ayant sa propre horloge et au moins un terminal fournissant un signal de données (RD Ext) à transmettre à un rythme et selon une phase définis par une horloge de terminal fournissant des signaux (RC Ext) dits d'horloge externe, ledit dispositif de synchronisation comportant un circuit tampon d'horloge et de données, caractérisé en ce qu'il comporte lui-même: un oscillateur à verrouillage de phase (90, 92, 94) pourvu d'une entrée dite de commande et destiné à engendrer un signal (XC0) dit d'horloge reconstituée à utiliser pour régler l'horloge de l'émetteur et pour synchroniser les données à envoyer à l'émetteur sous forme d'un train de données rconstituées (XD0); un circuit dit d'horloge commutée (98) relié à l'oscillateur à verrouillage de phase et comparant la phase du signal d'horloge reconstituée (XC0) à celle de l'horloge externe (RC Ext) à partir d'un instant dit initial et, engendrant un signal d'horloge commutée (SWC) oscillant à une fréquence dite rapide (FC) durant l'intervalle de temps représentant le premier déphasage à patir de l'instant initital entre les signaux XC0 et RC Ext, et à une fréquence dite lente (SC) subséquemment;

un registre à décalage d'horloge (100) dont l'entrée reçoit le signal d'horloge externe (RC Ext) et dont le décalage est commandé par le signal d'horloge commutée SWC, la sortie dudit registre à décalage d'horloge fournissant un signal de référence dit signal d'horloge décalée (X) envoyé à l'entrée de commande de l'oscillateur à verrouillage de phase;

un registre à décalage dedonnées (102) dont l'entrée reçoit le signal de données RD Ext et dont le décalage est commandé par le signal d'horloge commutée SWC; et,

une porte (104) dont l'entrée est reliée à la sortie dudit registre à décalage des données, ladite porte étant commandée conjointement par ledit signal d'horloge reconstituée et par un signal dit d'inhibition fourni par ledit registre à décalage d'horloge, ladite porte fournissant sur sa sortie les signaux de données (XD0) synchronisées à envoyer à l'émetteur (38).

2. Dispositif de synchronisation selon la revendication 1, caractérisé en ce que ledit signal d'inhibition est prélevé sur l'avant dernier étage du registre à décalage d'horloge.

3. Dispositif de synchronisation selon la revendication 1 ou 2 caractérisé en ce que ledit oscillateur à verouillage de phase comporte:

un oscillateur à quartz (90);

un circuit diviseur de fréquence (92) dont l'entrée est connectée audit oscillateur à quartz et dont la sortie fournit ledit signal d'horloge reconstituée; et,

un circuit comparateur de phases (94) comportant une pemière entrée dite entrée de commande recevant le signal dit de référence et une seconde entrée reliée à la sortie du circuit diviseur de fréquence, la sortie du comparateur de phases commandant l'accroissement ou la diminution d'une unité du coefficient de division du circuit diviseur, coefficient étant à l'origine fixé à une valeur N donnée.

4. Dispositif de synchronisation selon l'une des revendications 1 à 3 caractérisé en ce que ledit circuit d'horloge commutée comporte:

un circuit de comparaison de phases (128, 130, 132, 134, 136) comparant la phase du signal d'horloge reconstituée à celle de l'horloge externe;

des moyens de demande pour émettre fournissant un signal logique (RTS0) dit de demande, pour émettre, lequel est appliqué audit circuit de comparaison;

des moyens d'horloge pour fournir un signal d'horloge rapide (FC) et un signal d'horloge lents (SC); et,

des moyens de porte (142, 144) reliés au circuit de comparaison, et aux moyens d'horloges rapide et lente, et fournissant ledit signal d'horloge commutée.

5. Dispositif de synchronisation selon l'une des revendications 1 à 4 dans lequel:

ledit système d'émission de données est relié à au moins deux terminaux susceptibles de fournir chacun des données (XDi) à un rythme défini par son propre signal d'horloge externe (XCi) à partir d'instants définis par son signal de demande pour émettre RTSi, ledit dispositif de synchronisation étant caractérisé en ce qu'il comporte en outre un circuit dit d'exclusion (50) comportant des moyens pour sélectionner de manière exclusive le terminal dont la demande pour émettre RTSi a été formulée la première et orienter vers ledit dispositif tampon d'horloge et de données, les signaux d'horloge externe XCi et de données XDi du terminal sélectionné, lesquels signaux RTSi, XCi et XDi deviennent alors RTS0, XC0 et XD0 et ce jusqu'au passage de RTSi au niveau logique indiquant une fin de demande pour émettre.

6. Dispositif de synchronisation selon la revendication 5 caractérisé en ce que lesdits terminaux comportent des modems, auquel cas, les signaux RTSi sont remplacés par des signaux dis de détection de porteuse CDi.

7. Dispositif de synchronisation selon la revendication 6 caractérisé en outre en ce que ledit circuit tampon d'horloge et de données comporte en outre un compteur recevant lesdits signaux CD0 et RTS0 et fournissant un signal dit RTS0' obtenu par décalage du signal RTS0 et permettant de vider les registres à décalages de données et d'horloge.

**Patentansprüche**

1. Einrichtung zur Synchronisation eines Datenübertragungssystems der Art, die einen Sender (38) mit seinem eigenen Taktgeber und zumindest ein Terminal umfaßt, das ein Datensignal (RD Ext) liefert, das mit einem Takt und einer Phase übertragen werden muß, die von einem Terminal-Taktgeber definiert werden, dessen übertragene Signale (RC Ext) äußere Taktsignale genannt werden, wobei die genannte Synchronisationsvorrichtung eine Taktgeber- und Pufferschaltung umfaßt, die durch folgende Komponenten gekennzeichnet ist:

einen Oszillator mit Phasenverriegelung (90, 92, 94), der einen sogenannten Ansteuereingang umfaßt und zur Erzeugung eines sogenannten wiederhergestellten Taktsignals (XC0) dient, das zum Einstellen des Sender-Taktgebers und zur Synchronisation der Daten dient, die dem Sender in der Form eines wiederhergestellten Datensatzes (XD0) zu übermitteln sind;

eine Schaltung, geregelter Taktkreis (98) genannt, die mit dem Oszillator mit Phasenverriegelung verbunden ist und die Phase des wiederhergestellten Taktsignals (XC0) von einem sogenannten Anfangszeitpunkt an mit der Phase des äußeren Taktgebers (RC Ext) vergleicht und die ein geregeltes Taktsignal (SWC) erzeugt, das während des Zeitintervalls, das der ersten Phasenverschiebung seit dem Anfangszeitpunkt zwischen den Signalen XC0 und RC Ext entspricht, mit einer sogenannten schnellen Frequenz (FC) und anschließend mit einer langsamen Frequenz (SC) schwingt;

ein Taktschieberegister (100), dessen Eingang das äußere Taktsignal (RC Ext) erhält und dessen Verschiebung vom geregelten Taktsignal SWC gesteuert wird, wobei der Ausgang des genannten Taktschieberegisters ein Bezugssignal, verschobenes Taktsignal (X) genannt, liefert, das an den Ansteuereingang des Oszillators mit Phasenverriegelung gelegt wird;

ein Datenschieberegister (102), dessen Eingang das Datensignal RD Ext erhält und dessen Verschiebung vom geregelten Taktsignal SWC gesteuert wird; und

ein Gatter (104), dessen Eingang mit dem Ausgang des genannten Datenschieberegisters verbunden ist, wobei das genannte Gatter zusammenwirkend vom genannten wiederhergestellten Taktsignal und von einem sogenannten Sperrsignal geschaltet wird, das vom genannten Taktschieberegister generiert wird, und am Ausgang des genannten Gatters synchronisierte Datensignale (XD0) anstehen, die dem Emitter (38) zu übermitteln sind.

2. Synchronisationseinrichtung nach Anspruch 1, dadurch gekennzeichnet, daß das genannte Sperrsignal an der vorletzten Stufe des Taktschieberegisters abgenommen wird.

3. Synchronisationseinrichtung nach Anspruch 1 oder 2, dadurch gekennzeichnt, daß der genannte Oszillator mit Phasenverriegelung umfaßt;

einen Quarzoszillator (90);

eine Frequenzteilerschaltung (92), deren Eingang mit dem genannten Oszillator verbunden ist und deren Ausgang das genannte wiederhergestellte Taktsignal liefert; und

eine Phasendiskriminatorschaltung (94), die einen ersten sogenannten Ansteuereingang umfaßt, der das sogenannte Bezugssignal empfängt, und einen zweiten, mit dem Ausgang der Phasendiskriminatorschaltung verbundenen Eingang, wobei der Ausgang des Phasendiskriminators den Teilerbeiwert der Teilerschaltung um eine Einheit erhöht oder vermindert, während der genannte Teilerbeiwert ursprünglich auf einen gegebenen Wert N festgelegt war.

4. Synchronisationseinrichtung nach einem der Ansprüche 1 bis 3, daduch gekennzeichnet, daß die genannte geregelte Taktschaltung umfaßt:

eine Phasendiskriminatorschaltung (128, 130, 132, 134, 136), welche die Phase des wiederhergestellten Taktsignals mit der des äußeren Taktgebers vergleicht;

Mittel zum Anfordern einer Sendung, die ein sogenanntes logisches Anforderungssignal (RTS0) generieren, welches an die genannte Diskriminatorschaltung gelegt wird;

Taktgebermittel, um einen schnellen Taktimpuls (FC) und einen langsamen Taktimpuls (SC) zu generieren; und

Gattermittel (142, 144), die mit der Diskriminatorschaltung und mit den Mitteln des schnellen und des langsamen Taktgebers verbunden sind und die das genannte geregelte Taktsignal liefern.

5. Synchronisationseinrichtung nach einem der Ansprüche 1 bis 4, in welcher:

das genannte Datenübermittlungssystem mit zumindest zwei Terminalen verbunden ist, die jeweils Daten (XDi) erstellen können in einem Rhythmus, welcher von ihren eigenen äußeren Taktsignalen (XCi) von gewissen Zeitpunkten ab gesteuert wird, die von ihrem Anforderungssignal RTSi bestimmt werden, wobei die Synchronisationseinrichtung dadurch gekennzeichnet ist, daß sie zusätzlich eine sogenannte Inhibitionsschaltung (50) besitzt, die über Mittel verfügt, um exklusiv das Terminal zu wählen, dessen Anforderung, die zur Sendung der RTSi Signale dient, zuerst formuliert worden war, und um die äußeren Taktsignale XCi und die Daten XDi des gewählten Terminals der genannten Takt- und Datenpuffereinrichtung zuzuführen, wonach die Signale RTSi, XCi und XDi die Signale RTS0, XC0 und XD0 werden und das so lange, bis der Übergang von RTSi auf ein logisches Niveau stattfindet, welches das Ende einer Sendeanforderung anzeigt.

6. Synchronisationseinrichtung nach Anspruch 5, dadurch gekennzeichnet, daß die genannten Terminale Modems umfassen, in welchem Falle die RTSi Signale durch sogenannte CDi Trägerwellendetektionssignale ersetzt werden.

7. Synchronisationseinrichtung nach Anspruch 6, zusätzlich dadurch gekennzeichnet, daß die genannte Takt- und Pufferschaltung weiterhin einen Zähler umfaßt, der die genannten Signale CD0 und RTS0 empfängt und ein sogenanntes RTS0' Signal generiert, welches durch Verschiebung des RTS0 Signals erhalten wird, und es ermöglicht, die Daten- und Taktschieberegister zu leeren.

## Claims

1. A synchronization device for a data transmission system of the type comprising a transmitter (38) provided with its own clock and at least one terminal supplying a data signal (RD Ext) the transmission rate and the phase of which are defined by a terminal clock which generates external clock signals (RC Ext), said synchronization device including a clock and data buffering circuit and being characterized in that it comprises:

a phase-locked oscillator (90, 92, 94) provided with a control input and generating a recovered clock signal (XC0) serving to adjust the clock of the transmitter and to synchronize the data to be sent to said transmitter as a train of reconstructed data (XD0);

a switched clock circuit (98) connected to said phase-locked oscillator for comparing the phase of said recovered clock signal (XC0) with that of said external clock signal (RC Ext) starting from an initial instant, and for generating a switched clock signal (SWC) oscillating at a fast frequency (FC) during the time interval representing the first phase shift between signals XC0 and RC Ext that occurs after said initial instant and at a slow frequency (SC) thereafter;

a clock shift register (100) which receives said external clock signal (RC Ext) on its input and is controlled by said switched clock signal (SWC), and which provides at its output a reference signal called shifted clock signal (X) that is applied to the control input of said phase-locked oscillator;

a data shift register (102) which receives said data signal (RD Ext) on its input and is controlled by said switched clock signal (SWC); and a gate (104) whose input is connected to the output of said data shift register, said gate being controlled jointly by said recovered clock signal and by an inhibiting signal supplied by said clock shift register, said synchronized data signals (XD0) to be sent to said transmitter (38) being provided at the output of said gate.

2. A synchronization device according to claim 1, characterized in that said inhibiting signal is taken from the penultimate stage of said clock shift register.

3. A synchronization device according to claim 1 or 2, characterized in that said phase-locked oscillator comprises:

a cristal controlled oscillator (90);

a frequency divider circuit (92) whose input is connected to said cristal controlled oscillator and whose output provided said recovered clock signal; and

a phase comparison circuit (94) comprising a first input called control input which receives said reference signal and a second input connected to the output of said frequency divider circuit, with the division factor thereof, initially set to a given value N, being increased or decreased by one under control of the output from said phase comparison circuit.

4. A synchronization device according to any one of claims 1 to 3, characterized in that said switched clock circuit comprises:

a phase comparison circuit (128, 130, 132, 134, 136) for comparing the phase of said recovered clock signal with that of said external clock;

means for generating a logic signal called request to send signal (RTS0) which is applied to said comparison circuit;

clock means for generating said fast clock signal (FC) and said slow clock signal (SC): and gate means (142, 144) connected to said comparison circuit and to said fast and slow clock signal generating means, for generating said switched clock signal.

5. A synchronization device according to any one of claims 1 to 4, wherein:

said data transmission system is connected to at least two terminals capable each of supplying data (XDi) at a rate defined by its own external clock signal (XCi) from instants defined by its request to send signal (RTSi) synchronization device being characterized in that it further comprises an exclusion circuit (50) that includes means for selecting in an exclusive manner the terminal which first generated a request to send signal (RTSi) and for directing to said clock and data buffering device the external clock signals (XCi) and the data signals (XDi) from the selected terminal, said signals TRSi, XCi and XDi then becoming signals RTS0, XC0 and XD0 until such time as RTSi goes to the logic level that denotes the end of a request to send.

6. A synchronization device according to claim 5, characterized in that said terminals include modems, in which case the RTSi signals are replaced by carrier detection signals (CDi).

7. A synchronization device according to claim 6, further characterized in that said clock and data buffering circuit further includes a counter that receives said CD0 and RTS0 signals and provides a signal RTS0' that is obtained by shifting the RTS0 signal and causes the contents of said clock and data shift registers to be read out.

FIG. 1

FIG. 2

# FIG.3A

| I1 |
|---|
| RD1 |
| RC1 |
| CD1 |
| RFS1 |
| DSR1 |

| I'1 |
|---|
| RD1 |
| RC1 |
| CD1 |
| RFS1 |
| DSR1 |

RD0

RC0

CD0

RFS0

DSR0

MPS

| I2 |
|---|
| RD2 |
| RC2 |
| CD2 |
| RFS2 |
| DSR2 |

| I'2 |
|---|
| RD2 |
| RC2 |
| CD2 |
| RFS2 |
| DSR2 |

| I3 |
|---|
| RD3 |
| RC3 |
| CD3 |
| RFS3 |
| DSR3 |

| I'3 |
|---|
| RD3 |
| RC3 |
| CD3 |
| RFS3 |
| DSR3 |

34

FIG. 3B

# FIG. 4

# FIG.5

FIG. 6

# FIG. 7

# FIG. 8

$\overline{\delta}$

$\overline{T1}$
$\overline{T2}$

A    112

116

114

96Fb

$\mathcal{E}$
T1
T2

A

118

96Fb

$\overline{\delta}=\mathcal{E}=0$ { T1, T2 }

$\overline{\delta}=1$
$\mathcal{E}=0$ { T1, T2 }

$\overline{\delta}=0$
$\mathcal{E}=1$ { T1, T2 }

$\overline{\delta}=1$
$\mathcal{E}=1$ { T1, T2 }

# FIG.9

# FIG.10